# EUROPÄISCHE PATENTANMELDUNG

(11) **EP 0 779 517 A2**
(43) Veröffentlichungstag der Anmeldung: **18.06.1997**
(21) Anmeldenummer: 96118929.7
(22) Anmeldetag: 26.11.1996
(51) Int. Cl.: G01R 27/02, G01R 1/067

(54) **Verfahren zur Bestimmung eines elektrischen Oberflächenwiderstandes und Messvorrichtung**

(30) Priorität: 12.12.1995 DE 19546394
(71) Anmelder: SIEMENS AKTIENGESELLSCHAFT, 80333 München (DE)
(72) Erfinder: Wilde, Rüdiger, 81476 München (DE)

(57) **Zusammenfassung**

Zur Ermittlung eines Oberflächenwiderstandes an durchgehenden und ebenen Oberflächen kann eine DIN-Elektrode eingesetzt werden. Zur Ermittlung eines Oberflächenwiderstandes an strukturierten Oberflächen wie beispielsweise an einem Tray 1 zur Verpackung von elektronischen Bauelementen versagt diese Meßmethode. Es wird vorgeschlagen, als Meßelektrode zwei Kontaktgummis 3 zu verwenden, zwischen denen eine Abstandsfläche 5 als Teil der Oberfläche des Trays 1 eingeschlossen ist. Die Abstandsfläche 5 hat die Form eines Quadrates und es wird ein Oberflächenwiderstand in Ω/□ gemessen.

## Beschreibung

Die Erfindung betrifft ein Verfahren zur Bestimmung eines elektrischen Oberflächenwiderstandes sowie eine Meßvorrichtung. Dabei werden insbesondere Werkstücke mit strukturierter Oberfläche betrachtet, bei der herkömmliche standardisierte Elektroden zur Messung eines Oberflächenwiderstandes aufgrund der Struktur des Werkstückes nicht einsetzbar sind.

Zur Ermittlung von elektrischen Oberflächenwiderständen werden teilweise genormte Elektroden eingesetzt, wie beispielswiese die DIN-Elektrode. Diese besteht aus zwei Elektroden, deren Auflageflächen einen Vollkreis mit einem konzentrisch dazu angeordneten Ring bilden. Zwischen dem außenliegenden Ring und dem innenliegenden Vollkreis wird eine ebenfalls ringförmige Fläche, die der Beabstandung der beiden Elektroden entspricht, eingeschlossen. Diese Meßanordnung nach der DIN (Deutsche Industrie Norm) weist einen äußeren Durchmesser von 80 bis 100 mm auf. Sie wird zur Messung von Oberflächenwiderständen an Gegenständen mit durchgehender und ebener Oberfläche verwendet. Dies sind beispielsweise Bodenbeläge oder ähnliches.

Die Ermittlung des Oberflächenwiderstandes eines beispielsweise aus Kunststoff hergestellten Tablettes bzw. einer Ablageschale für elektronische Bauelemente ist besonders wichtig. Werden elektronische Bauelemente in die Mulden eines Trays (Einsatz, Ablageschale, Tablett oder Wechselplatte) eingelegt, so können durch elektrostatische Aufladungen am Bauelement z. B. durch triboelektrische Aufladungen kurzzeitig hohe Spannungen fließen, die zu einer Schädigung eines Bauelementes führen. Um diesen Vorgängen entgegenzutreten, sind verschiedene Maßnahmen ergriffen worden, wie beispielsweise die Forderung nach einer bestimmten Bandbreite des Oberflächenwiderstandes.

Die im Stand der Technik bekannte DIN-Elektrode bietet zwar durch die entsprechende Normung einheitliche Maßstäbe für die Messung von Oberflächenwiderständen an, ist jedoch auf Gegenstände mit ebener und relativ großflächiger Oberfläche eingegrenzt. Sollen Gegenstände mit unterbrochenen Strukturen bzw. strukturierter Oberflächen gemessen werden, so ist die DIN-Elektrode beispielsweise nicht einsetzbar. Dies gilt insbesondere für Verpackungstrays für elektronische Bauelemente in der Halbleiterindustrie.

Verschiedene Hersteller bedienen sich verschiedenartiger nicht einheitlicher Meßmethoden.

Der Erfindung liegt die Aufgabe zugrunde, ein Verfahren zur Bestimmung eines elektrischen Oberflächenwiderstandes, sowie eine entsprechende Meßanordnung zur Verfügung zu stellen, womit Oberflächenwiderstände an Gegenständen meßbar sind, deren oberflächliche Strukturen fein gegliedert sind, so daß keine größere ebene Fläche zur Verfügung steht. Die Lösung dieser Aufgabe geschieht durch die Merkmale des Anspruches 1 bzw. des Anspruches 5.

Weitere vorteilhafte Ausgestaltungen können den Unteransprüchen entnommen werden.

Der Erfindung liegt die Erkenntnis zugrunde, daß eine kleine nach außen hin abtastbare einheitliche Oberflächenstruktur wie beispielsweise ein Steg zur Ermittlung eines einheitlichen Oberflächenwiderstandes ausreicht, wenn eine entsprechende Elektrode eingesetzt wird. Diese Elektrode besteht entsprechend der DIN-Elektrode aus zwei Elektroden, die gegeneinander beabstandet sind. Diese beiden Elektroden sind ungefähr quaderförmig, parallel zueinander ausgerichtet und gegeneinander beabstandet. Ihre Auflageflächen, die annähernd gleich sind, liegen in einer Ebene. Die beiden Elektroden können auf eine kleine einheitliche Oberfläche an einem strukturierten Bauteil aufgesetzt werden, wobei ihre Ausrichtung quer zu beispielsweise einem Steg verläuft. Die Beabstandung der beiden Elektroden ist identisch mit der Breite des Steges. Somit wird ein Teil der Oberfläche des zu prüfenden Gegenstandes in Form eines Quadrates umfaßt. Die Kantenlängen sind dabei variabel, solange immer ein Quadrat gebildet wird.

Im folgenden wird anhand von schematischen Figuren ein Ausführungsbeispiel geschrieben.
Figur 1 zeigt eine DIN-Elektrode nach dem Stand der Technik,
Figur 2 zeigt eine Meßanordnung an einem Tray 1 mit Kontaktgummis 3,
Figur 3 zeigt eine Draufsicht der Meßanordnung nach Figur 2.

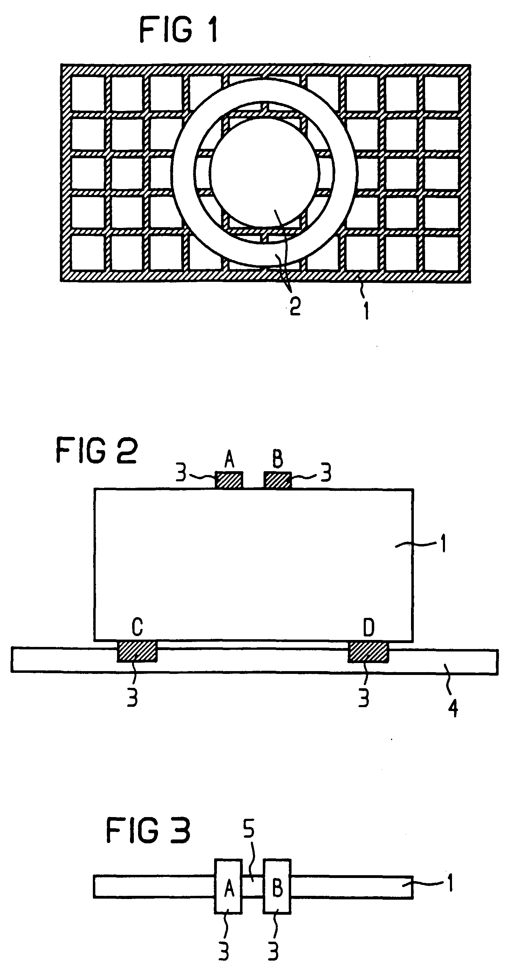

In der Figur 1 ist andeutungsweise ein Tray 1 in der Draufsicht dargestellt. Dabei sind die Oberflächenstrukturen von rechtwinklig angeordneten Schalen zu erkennen, in die jeweils ein Bauelement zum Transport in der Fertigung oder zum allgemeinen Transport eingelegt wird. Die Auflagefläche der Elektrode 2 nach dem Stand der Technik (DIN-Elektrode) ist in der Mitte der Figur 1 eingezeichnet. Es ist ersichtlich, daß diese Elektrode versagt, da sie nicht ganzflächig aufliegt.

In der Figur 2 ist ein Tray 1 auf einer Auflage 4 hochkant aufgestellt. Die Figur 2 zeigt die Seitenansicht. Hier wird ein geeigneter Meßaufbau mit leitenden Gummielektroden, den Kontaktgummis 3, dargestellt, mit dem reproduzierbare Oberflächen- und Durchgangswiderstände ermittelt werden können. Das hier dargestellte Tray, das nach der JEDEC-Norm (Join Electron Device Engineering) ausgelegt ist, hat beispielsweise eine Materialstärke am Außenrand von 7,62 mm, wobei davon 6,2 mm für eine angesprochene Messung verwertbar sind. Ein derartiges Tray wird als JEDEC-TMT-Tray bezeichnet (Thin Matrix Tray).

Die Kontaktgummis 3, die mit A und B bezeichnet sind, werden in Figur 3 nochmals in der Draufsicht dargestellt. Diese in Quaderform ausgeführten Elektroden setzen auf dem Rand des Trays 1 auf und schließen eine Abstandsfläche 5 ein, die ein Quadrat darstellen muß. Nachdem die Höhe des Trays 1 festliegt, muß die Beabstandung der Kontaktelektroden 3A, 3B das gleiche Maß aufweisen. Somit wird ein Oberflächenwiderstand mit der Dimension Ω/□ gemessen. Ein sinnvoller Bereich für einen Oberflächenwiderstand liegt zwischen 10⁵ und 10⁹ Ω/□. Die Messung des Oberflächenwiderstandes zwischen den Elektroden 3A und 3B setzt voraus, daß diese beiden Elektroden aktiviert, d. h. an eine entsprechende Stromversorgung und Meßmimik angeschlossen sind.

Um Inhomogenitäten innerhalb des Materials eines Trays 1 aufzuspüren, kann in der Anordnung entsprechend Figur 2 der Durchgangswiderstand in verschiedenen Richtungen gemessen werden. So kann beispielsweise von A nach C oder A nach D oder B nach C oder B nach D gemessen werden. Liegen die Durchgangswiderstände beispielsweise in einer Schwankungsbreite von absolut 10¹, so können die Inhomogenitäten vernachlässigt werden und das Tray 1 muß nicht verworfen werden.

Die Draufsicht auf die Meßanordnung entsprechend Figur 2 wird in Figur 3 dargestellt. Für verschiedene Höhen bzw. Stärken eines Trays 1 wird der Abstand der Kontaktgummis 3A und 3B entsprechend eingestellt. Die Verwendung von Kontaktgummis ist vorgesehen, damit durch leichtes Andrücken ein vollflächiger Kontakt zustandekommt. Die Kontaktgummis 3 können prinzipiell durch schmale Stege dargestellt werden. Eine Veränderung der Auflagefläche der Kontaktgummis 3 verändert die Messungen in äußerst geringem Maß. Wesentlich ist die Beibehaltung eines Quadrates als Abstandsfläche 5. Somit ist ebenso denkbar, daß die Breite der quaderförmigen Kontaktgummis 3 in Figur 3 auch größer als die Kantenlänge der Abstandsfläche 5 sein kann. Die Kontaktgummis 3 sollten jedoch eine Breite von mindestens 5 mm aufweisen. Die Länge eines Trays beträgt beispielsweise 300 mm bei einer Randhöhe von 7,62 mm.

In dem beschriebenen Ausführungsbeispiel wird der Oberflächenwiderstand jeweils auf ein Quadrat bezogen. Dies deckt sicher eine Vielzahl von in der Praxis vorhandenen geometrischen Ausgestaltungen von zu prüfenden Werkstücken ab.

## Patentansprüche

1. Verfahren zur Bestimmung eines elektrischen Oberflächenwiderstandes an einem strukturierten Werkstück, insbesondere einem Tray für elektronische Bauelemente, durch Aufsetzen zweier paralleler länglicher und gegenseitig beabstandeter Elektroden auf die eine nichtstrukturierte Außenseite des Werkstückes, wobei als Abstandsfläche zwischen den Elektroden ein von den Elektroden und der Oberflächenstruktur der Außenseite des Werkstückes gebildetes Quadrat dargestellt wird, auf das der Widerstand bezogen wird und wobei zur zusätzlichen Messung von elektrischen Durchgangswiderständen zur Feststellung von Inhomogenitäten im Material zusätzlich mindestens eine Elektrode auf der relativ zum Aufsetzort der erstgenannten Elektroden für den oberflächenwiderstand gegenüberliegenden Seite des Werkstückes aufgesetzt ist und Durchgangswiderstände in verschiedenen Durchgangsrichtungen am Werkstück meßbar sind.

2. Verfahren nach Anspruch 1, worin die Elektroden aus Kontaktgummi bestehen.

3. Meßvorrichtung zur Bestimmung eines elektrischen Oberflächenwiderstandes an einem strukturierten Werkstück, bestehend aus zwei annähernd gleich großen quaderförmigen Elektroden, die parallel zueinander und gegenseitig beabstandet ausgerichtet sind, deren Auflageflächen gleich groß sind und in einer Ebene liegen, so daß der gegenseitige Abstand der Breite eines Steges des zu prüfenden Werkstückes entspricht, auf den die Elektroden in Querrichtung aufsitzen und ein quadratisches Oberflächenelement eingeschlossen ist.
